# EUROPEAN PATENT APPLICATION

(11) **EP 4 199 112 A1**
(43) Date of publication of application: **21.06.2023**
(21) Application number: 21215370.4
(22) Date of filing: 17.12.2021
(51) Int. Cl.: H01L 29/775, H01L 27/092, H01L 21/336, H01L 21/8238, H01L 21/822, H01L 29/423, H01L 29/06, B82Y 10/00

(54) **A METHOD FOR FORMING A SEMICONDUCTOR DEVICE**

(71) Applicant: IMEC VZW, 3001 Leuven (BE)
(72) Inventor: CHAN, Boon Teik, 3012 Wilsele (BE); VANDOOREN, Anne, 5032 Mazy (BE); RYCKAERT, Julien, 1030 Schaerbeek (BE); HORIGUCHI, Naoto, 3000 Leuven (BE)
(74) Representative: AWA Sweden AB

(57) **Abstract**

The disclosure relates to a method for forming a semiconductor device, the method comprising:
forming a device layer stack on a substrate, the device layer stack comprising:
- a first sub-stack comprising a first sacrificial layer and on the first sacrificial layer a channel layer defining a topmost layer of the first sub-stack, and
- a second sub-stack on the first sub-stack and comprising a first sacrificial layer defining a bottom layer of the second sub-stack, and a second sacrificial layer on the first sacrificial layer,

wherein said first sacrificial layers are formed of a first sacrificial semiconductor material, the second sacrificial layer is formed of a second sacrificial semiconductor material, and the channel layer is formed of a semiconductor channel material, and
wherein a thickness of the second sub-stack exceeds a thickness of the first sacrificial layer of the first sub-stack.

The method comprises replacing the second sacrificial layer of the second sub-stack with a dielectric layer; forming recesses in the device layer stack by laterally etching back end surfaces of the first sacrificial layers of the first and second sub-stacks from opposite sides of the sacrificial gate structure; and forming inner spacers in the recesses.

## Description

### Technical field

The present disclosure relates to a method for forming a semiconductor device.

### Background

Modern semiconductor integrated circuit technology includes horizontal channel transistors, for example the horizontal or lateral nanowire FET (NWFET) and nanosheet FET (NSHFET). These transistor structures typically include a source, a drain, a channel comprising one or more nanowire or nanosheet-shaped horizontally extending channel layers and a gate stack. In a gate-all-around (GAA) design, the gate stack wraps all-around the channel layers.

Fabrication methods for horizontal NWFET or NSHFET devices may be based on processing of a semiconductor layer stack of alternating sacrificial layers and channel layers, e.g. of a nanowire or nanosheet shape. The processing may comprise forming of a sacrificial gate across the layer stack, source/drain epitaxy on the channel layers at opposite sides of the sacrificial gate, and subsequent to sacrificial gate removal, gate stack deposition. The processing may (e.g. after sacrificial gate removal and prior to gate stack deposition) comprise a step of etching away sacrificial layer material above and below the channel layers to form "released" channel layers, such that the gate stack subsequently may be formed to surround the channel layers. Preceding the channel release, so-called "inner spacers" may be formed on end surfaces of the sacrificial layers by laterally recessing the sacrificial layers from both sides of the sacrificial gate, and filling the recesses with a dielectric material. The inner spacers may thus during the subsequent channel release step mask the source/drain regions from the etching. The inner spacers may further provide physical and electrical separation between the source/drain regions and the gate metal in the final device.

The "forksheet" device is a more recent type of horizontal NSHFET device design, allowing a pFET and an nFET to be provided adjacent to each other in relatively close proximity, each controlled by a fork-shaped gate structure and separated by an insulating wall. The insulating wall may be formed between the p- and n-type device region before gate patterning. The wall may thus separate the p-gate trench from the n-gate trench, allowing a much tighter n-to-p spacing.

Forksheet device fabrication method may comprise processing a pair of layer stacks of alternating sacrificial layers and channel layers. To facilitate a tight n-to-p spacing, the layer stacks may be separated by a trench filled with insulating material to form the insulating wall. Device fabrication may then proceed by applying the fabrication approach outlined above to each of the stacks. To allow for an increased height of the insulating wall above the topmost channel layer of each layer stack, a top sacrificial layer may be provided having a greater thickness than the lower sacrificial layers of the layer stacks. The top sacrificial layer may be removed together with the lower sacrificial layers during the channel release.

The Complementary Field-Effect Transistor (CFET) device is a transistor device having a complementary pair of FETs, stacked on top of each other (e.g. a pFET bottom device and an nFET top device, or vice versa). The CFET device allows a reduced footprint compared to a traditional side-by-side arrangement of a pFET and nFET.

A CFET device comprising GAA NW- or NSHFET bottom and top devices may be formed by "monolithic" processing of a semiconductor layer stack of alternating sacrificial layers and channel layers using a fabrication approach as outlined above, to form the bottom device from a lower part of the layer stack (a lower sub-stack) and the top device from an upper part of the layer stack (an upper sub-stack). The gate stack may be deposited over the bottom and top device from a same gate trench, wherein a gate electrode which is physically and electrically common to the top and bottom device may be formed. However, it may still be desirable to provide different work function metals (WFMs) for the bottom device and the top device. Hence, the gate stack formation may comprise deposition of a WFM optimized for the bottom device (e.g. a p-type WFM for a p-type bottom device), followed by an etch back to remove the WFM (e.g. p-type WFM) from the top device (e.g. an n-type top device) and thereafter depositing a WFM optimized for the top device (e.g. an n-type WFM).

To facilitate individual processing of the bottom and top device (e.g. individual source/drain epitaxy and the WFM etch back), the lower and upper sub-stacks of the layer stack may be separated by an intermediate sacrificial layer having a greater thickness than the sacrificial layers of the sub-stacks. A vertical separation between topmost channel layer of the lower sub-stack and the bottom channel layer of the upper sub-stack may hence be increased. The top sacrificial layer may be removed together with the sacrificial layers of the lower and upper sub-stacks during the channel release.

### Summary

In view of the above, the forksheet device and the CFET device are both examples of devices which may benefit from a thicker top (the forksheet device) or intermediate (the CFET device) sacrificial layer. However, it has been realized by the inventors that a thicker top/intermediate sacrificial layer may complicate formation of inner spacers. Inner spacer formation typically involves on conformal deposition of spacer material to "pinch-off" or "close" the recesses formed during sacrificial layer recess, followed by an isotropic etch back to remove inner spacer material deposited outside the recesses. However, a thicker top or intermediate sacrificial layer may prevent pinch-off, which in turn may result in failure to form inner spacers at the thicker sacrificial layer.

Accordingly, it is an object of the present inventive concept to provide method for forming a semiconductor device comprising inner spacers, which method is compatible with both forksheet and (monolithic) CFET device fabrication. Further and alternative objectives may be understood from the following.

According to an aspect there is provided a method for forming a semiconductor device, the method comprising:
forming a device layer stack on a substrate, the device layer stack comprising:
   - a first sub-stack comprising a first sacrificial layer and on the first sacrificial layer a channel layer defining a topmost layer of the first sub-stack, and
   - a second sub-stack on the first sub-stack and comprising a first sacrificial layer defining a bottom layer of the second sub-stack, and a second sacrificial layer on the first sacrificial layer,
wherein said first sacrificial layers are formed of a first sacrificial semiconductor material, the second sacrificial layer is formed of a second sacrificial semiconductor material, and the channel layer is formed of a semiconductor channel material, and
wherein a thickness of the second sub-stack exceeds a thickness of the first sacrificial layer of the first sub-stack;
forming a sacrificial gate structure extending across the device layer stack, the sacrificial gate structure comprising a sacrificial gate body and a first spacer on opposite sides of the sacrificial gate body;
etching through the device layer stack while using the sacrificial gate structure as an etch mask such that portions of said layers of the device layer stack are preserved underneath the sacrificial gate structure;
subsequently, replacing the second sacrificial layer of the second sub-stack with a dielectric layer, comprising removing the second sacrificial layer of the second sub-stack to form a space in the second sub-stack by selectively etching the second sacrificial semiconductor material, and thereafter filling the space with a first dielectric material;
forming recesses in the device layer stack by laterally etching back end surfaces of the first sacrificial layers of the first and second sub-stacks from opposite sides of the sacrificial gate structure;
forming inner spacers in the recesses;
subsequently, forming source and drain regions by epitaxially growing semiconductor material on end surfaces of the channel layer exposed at opposite sides of the sacrificial gate structure;
subsequently, forming a gate trench by removing the sacrificial gate body;
removing the first sacrificial layer of the first and second sub-stacks by selectively etching the first sacrificial semiconductor material from the gate trench; and
forming a gate stack in the gate trench such that the gate stack surrounds the channel layer.

According to the method, a FET device comprising a channel layer and a gate stack at least partly surrounding the channel layer may be formed.

The method is compatible with forksheet device fabrication, wherein the second sub-stack may be a topmost sub-stack, and CFET device fabrication, wherein the second sub-stack may be an intermediate sub-stack located between the first (lower) sub-stack and a second (upper) sub-stack. In either case, the provision of a sub-stack of sacrificial layers (i.e. the second sub-stack) on the channel layer of the first sub-stack enables a number of advantages:
As the second sub-stack is thicker than the thickness of the first sacrificial layer of the first sub-stack, a greater thickness of sacrificial material may be provided on the channel layer. The second sub-stack enables may thus provide a function similar to the above-discussed single "thicker" top sacrificial layer, e.g. enabling a higher insulating wall in a forksheet device, or an increased vertical separation between the bottom and top device of a CFET device.

As the second sacrificial layer of the second sub-stack is formed of a second sacrificial material different from the first sacrificial material, the second sacrificial layer may be selectively replaced by a dielectric layer. This obviates the need for recessing the second sacrificial layer and providing inner spacers thereon. As the second sacrificial layer need not be recessed, the dielectric layer may be coextensive with the channel layer. The dielectric layer may remain in the final device as a "dummy channel" which, as it is insulating, may have a minimal influence on the electrical performance of the final device.

Furthermore, as the first sacrificial layers of the first and the second sub-stack are formed of the first sacrificial semiconductor material, the first sacrificial layer of the second sub-stack may be recessed together with the first sacrificial layer of the first sub-stack. Inner spacers may thus be provided on end surfaces of the first sacrificial layers of the first and second sub-stacks.

Although the method may advantageously be used to form both forksheet and CFET devices, it is contemplated that the method may be used also to form other horizontal channel FET devices (e.g. NW- of NSHFETs) requiring inner spacers, and which may benefit from an increased sacrificial material thickness over a topmost channel layer, or between channel layers.

By the term "device layer stack" is hereby meant a structure of layers, sequentially formed on top of each other. The device layer stack may in particular be fin-shaped.

The first sub-stack designates a first subset of consecutive layers of the device layer stack and the second sub-stack designates a second subset of consecutive layers of the device layer stack.

By the wording "a first layer on a second layer" in reference to any of the layers (or sub-stacks) of the device layer stack is hereby meant that the first layer is arranged directly on (i.e. in abutment with) the second layer.

Accordingly, the first sacrificial layer of the first sub-stack, the channel layer, the first sacrificial layer of the second sub-stack and the second sacrificial layer of the second sub-stack refer to a consecutive sequence of layers. Correspondingly, the second sub-stack is consecutive to the first sub-stack.

Relative spatial terms such as "topmost", "bottom", "lower", "vertical", "stacked on top of", are herein to be understood as denoting locations or directions within a frame of reference of the semiconductor device. In particular, the terms may be understood in relation to a normal direction to the substrate on which the device layer stack is formed, or equivalently in relation to a bottom-up direction of the device layer stack. Correspondingly, terms such as "lateral" and "horizontal" are to be understood as locations or directions parallel to the substrate.

The term "thickness" is to be understood as a dimension of a structure (e.g. a layer of a sub-stack) as seen along a normal to a surface underlying the structure (e.g. the layer of the sub-stack). For example, the thickness of a layer of the device layer stack, or the thickness of the second sub-stack, may refer to the thickness dimension of the layer/sub-stack as seen along the bottom-up direction of the device layer.

By the term "inner spacers" is hereby meant dielectric layer portions formed selectively in the recesses to cover end surfaces of the first sacrificial layers. Forming the inner spacers may comprise conformally depositing an inner spacer material layer and subsequently etching the inner spacer material layer such that a discrete portion of the inner spacer material layer remain in each recess to form an inner spacer therein. The spacer layer may in particular be etched using an isotropic etching process. An isotropic etching process allows the inner spacer material layer to be etched at a uniform rate (at least substantially). Hence, the structures covered by the inner spacer material layer may remain covered from the etchants by the inner spacer material layer substantially until the channel layer end surfaces are exposed, wherein the etching may be stopped. The inner spacer material layer may be deposited with a thickness such that the recesses are pinched-off (i.e. closed).

By the term "conformal deposition" is hereby meant a deposition process resulting in a conformally growing layer or film. Conformal deposition may be achieved using an atomic layer deposition (ALD) process.

In some embodiments, the first sacrificial layers of the first and second sub-stacks may have a uniform or at least similar thickness. This enables the formation of recesses of uniform or similar height within which the inner spacers may be uniformly formed, which in turn enables the inner spacers to uniformly remain in the recesses. Furthermore, it enables a uniform removal of the first sacrificial layer portions in a processing step, e.g. prior to gate stack formation.

As used herein the wording "similar thickness", when used in connection with layers of the device layer stack (e.g. any first, second and/or third sacrificial layers), is to be understood as the layers having thicknesses sufficiently similar to allow the inner spacer material layer to be deposited to completely fill (i.e. to pinch-off) each recess, such that inner spacers may be formed therein.

For example, a thickness difference between any two of the first sacrificial layers may be at most 1 nm. The first sacrificial layers may each be formed with a thickness of 3-10 nm.

In some embodiments, the act of replacing the second sacrificial layer of the second sub-stack with the dielectric layer may be performed prior to the forming of the recesses. This may facilitate the forming of the recesses as the dielectric material of the dielectric layer may provide a greater etch contrast towards the (semiconductor) first sacrificial material.

In some embodiments, the second sub-stack may comprise one or more units of a first sacrificial layer of the first sacrificial semiconductor material and a second sacrificial layer of the second sacrificial semiconductor material.

The method may accordingly comprise replacing each second sacrificial layer of the second sub-stack with a respective dielectric layer to form respective spaces in the second sub-stack by selectively etching the second sacrificial semiconductor material, and thereafter filling each space with the first dielectric material.

The act of forming the recesses may comprise laterally etching back end surfaces of each first sacrificial layer of the second sub-stack from opposite sides of the sacrificial gate structure.

The method may comprise removing each first sacrificial layer of the first and second sub-stacks by selectively etching the first sacrificial semiconductor material from the gate trench.

A second sub-stack with two or more units of first and second sacrificial layers, enables forming of a thicker second sub-stack, or a reduced thickness of the second sacrificial layers for a same thickness of the second sub-stack. A smaller thickness of the second sacrificial layer(s) may facilitate the replacement with the dielectric layer(s) as the second sacrificial layer(s) may be reduced more quickly, thus reducing the expose of the first sacrificial layers and the channel layer to the etchants.

In some embodiments the channel material may be Si₁₋ₓGeₓ, the first sacrificial material may be Si_{1-y}Ge_{y} and the second sacrificial material may be Si_{1-z}Ge_{z}, wherein 0 ≤ x < y < z. A Si- and SiGe-based layer stack enables forming of high-quality channel layers and first and second sacrificial layers which may be processed selectively to the channel layers.

As the second sub-stack is thicker than the thickness of the first sacrificial layer of the first sub-stack, a greater total thickness of sacrificial material may be provided on the channel layer with a comparably smaller thickness of Si_{1-z}Ge_{z}. A reduced growth thickness of Si_{1-z}Ge_{z} may allow a reduced amount of growth defects.

In some embodiments, the second sub-stack may further comprise a third sacrificial layer of the first sacrificial material forming a topmost layer of the second sub-stack, and wherein the device layer stack may further comprise a third sub-stack on the second sub-stack, the third sub-stack comprising a channel layer of the channel material and forming a bottom layer of the second sub-stack, and a first sacrificial layer of the first sacrificial semiconductor material on the channel layer.

The provision of the third sub-stack comprising the channel layer enables forming of a further FET device (e.g. a top device) over dielectric layer. This in turn enables forming of a CFET device. Having the third sacrificial layer of the first sacrificial material as a topmost layer of the second sub-stack allows the channel layer of the third sub-stack to be vertically spaced apart from the dielectric layer. This enables forming the gate stack to surround also the channel layer of the third sub-stack. Additionally, as the third sacrificial layer is formed of a same material as the first sacrificial layers of the first, second and third sub-stacks, the third sacrificial layer may be processed in parallel with the first sacrificial layers.

Accordingly, the act of forming recesses may comprise laterally etching back end surfaces of each first sacrificial layer of the first, second and third sub-stack and the third sacrificial layer of the second sub-stack from opposite sides of the sacrificial gate structure.

The act of forming source and drain regions may further comprise epitaxially growing semiconductor material on end surfaces of the channel layer of the third sub-stack, exposed at opposite sides of the sacrificial gate structure. The source and drain regions formed on the channel layer end surfaces of the first sub-stack may be of a first conductivity type and the source and drain regions formed on the channel layer end surfaces of the third sub-stack may be of a second opposite conductive type. The first and second conductivity types may be a p-type and an n-type, or vice versa.

The method may comprise removing each first sacrificial layer of the first, second and third sub-stacks and the third sacrificial layer of the third sub-stack by selectively etching the first sacrificial semiconductor material from the gate trench.

The act of forming the gate stack may comprise forming the gate stack in the gate trench such that the gate stack surrounds the channel layer of the first sub-stack, each dielectric layer of the second sub-stack, and the channel layer of the third sub-stack.

In some embodiments, the second sub-stack may comprise exactly one (i.e. a single) unit of a first sacrificial layer of the first sacrificial semiconductor material and a second sacrificial layer of the second sacrificial semiconductor material, and the third sacrificial layer of the first sacrificial semiconductor material on the one (single) unit. The second sub-stack may hence be formed as a tri-layer stack, with a bottom sacrificial layer and a topmost sacrificial layer of the first sacrificial material, and the second sacrificial layer of the second sacrificial material between the bottom and topmost sacrificial layers.

The second sacrificial layer of the second sub-stack may have a greater thickness than each of the first and third sacrificial layers of the second sub-stack. The first and third sacrificial layers of the second sub-stack may have a uniform or at least similar thickness. In particular, the first sacrificial layer of the first sub-stack, the first and third sacrificial layer of the second sub-stack, and the first sacrificial layer of the third sub-stack may have a uniform or at least similar thickness. For example, a thickness difference between any two of the first and third sacrificial layers may be at most 1 nm. The sacrificial layers may each be formed with a thickness of 3-10 nm.

In some embodiments, the second sub-stack may comprise exactly two units of a first sacrificial layer of the first sacrificial semiconductor material and a second sacrificial layer of the second sacrificial semiconductor material on the first sacrificial layer, and the third sacrificial layer of the first sacrificial semiconductor material on an upper one of the two units. The second sub-stack may hence be formed as a five-layer stack, with a bottom sacrificial layer and a topmost sacrificial layer of the first sacrificial material, and two second sacrificial layer of the second sacrificial material separated by a middle sacrificial layer of the first sacrificial material between the two second sacrificial layers.

Each first and second sacrificial layers of the second sub-stack, and the third sacrificial layer may have a uniform or at least similar thickness. In particular, the first sacrificial layer of the first sub-stack, each first and second sacrificial layers of the second sub-stack, the third sacrificial layer of the second sub-stack, and the first sacrificial layer of the third sub-stack may have a uniform or at least similar thickness. For example, a thickness difference between any two of the first, second and third sacrificial layers may be at most 1 nm. The sacrificial layers may for example each be formed with a thickness of 3-10 nm.

In some embodiments, forming the gate stack may further comprise:
conformally depositing a gate dielectric layer and then a first gate work function metal in the gate trench,
subsequently, forming a block mask with a thickness such that the first gate work function metal surrounding the channel layer of the first sub-stack is covered and the first gate work function metal surrounding the channel layer of the third sub-stack is exposed,
removing the first gate work function metal from the channel layer of the third sub-stack while using the block mask as an etch mask, and
subsequently conformally depositing a second gate work function metal in the gate trench.

The block mask may hence facilitate providing different gate work function metals (WFM) at the channel layer(s) of the first sub-stack and the channel layer(s) of the third sub-stack.

The dielectric layer(s) of the second sub-stack may provide an increased process window for the block mask formation by allowing an increased vertical separation between the (topmost) channel layer of the first sub-stack and the (bottom) channel layer of the third sub-stack.

The block mask may be removed subsequent to removing the first gate work function metal and prior to depositing the second gate work function metal.

Forming the block mask may comprise depositing a block mask material filling the gate trench, and subsequently etching back the deposited block mask material (e.g. top-down) such that the first gate work function metal surrounding the channel layer of the third sub-stack is exposed and such that the first gate work function metal surrounding the channel layer of the first sub-stack remains covered.

The deposited block mask material may be etched using an isotropic etching process. This may facilitate etching back portions of the block mask material overlapped (i.e. shadowed) by the channel layer(s) of the third sub-stack and the dielectric layer.

In the above, reference has been made mainly to a single first sacrificial layer and channel layer of the first sub-stack and the third sub-stack, respectively. However, the first and/or third sub-stack may each comprise more than one channel layer and first sacrificial layer.

In some embodiments, the first sub-stack may comprise one or more units of a first sacrificial layer of the first sacrificial semiconductor material and a channel layer of the channel material on the first sacrificial layer.

In some embodiments, the third sub-stack may comprise one or more units of a channel layer of the channel material and a first sacrificial layer of the first sacrificial semiconductor material on the channel layer.

It is to be understood that any process step or any discussion relating to a first sacrificial layer of the first sacrificial material of the first or third sub-stack may be applied correspondingly to any further first sacrificial layer of the first or third sub-stack. Correspondingly, any process step or any discussion relating to the channel layer of the first or third sub-stack may be applied correspondingly to any further channel layer of the first or third sub-stack.

In some embodiments, the device layer stack may be a first device layer stack, and the channel layer of the first sub-stack may form a top-most channel layer of the first device layer stack. The method may further comprise:
forming a second device layer stack on the substrate, the second device layer stack having a same composition as the first device layer, and the first and second device layer stacks being separated by a vertically oriented insulating wall, wherein the layers of the first and second sub-stacks of the first device layer stack and the layers of the first and second sub-stacks of the second device layer stack abut opposite side surfaces of the insulating wall.

The method may comprise forming the sacrificial gate structure to extend across the first and second device layer stacks and the insulating wall, and subsequently applying each one of the afore-mentioned acts applied to the (first) device layer stack also to the second device layer stack, e.g. etching through the device layer stack, replacing the second sacrificial layer of the second sub-stack, forming recesses, forming inner spacers, forming source and drain regions, forming a gate trench, removing the first sacrificial layers of the first and second sub-stacks, and forming a gate stack to each of the first device layer stack and the second device layer stack.

The source and drain regions formed on the channel layer end surfaces of the first device layer stack may be of a first conductivity type and the source and drain regions formed on the channel layer end surfaces of the second device layer stack may be of a second opposite conductive type. The first and second conductivity types may be a p-type and an n-type, or vice versa.

The removal of the sacrificial gate structure may result in forming of a gate trench comprising a first gate trench portion at the first device layer stack and a second gate trench portion at the second device layer stack. Forming the gate stack may comprise depositing a first gate work function metal in the first gate trench portion and a second gate work function metal in the second gate trench portion.

### Brief description of the drawings

The above, as well as additional objects, features and advantages, may be better understood through the following illustrative and non-limiting detailed description, with reference to the appended drawings. In the drawings like reference numerals will be used for like elements unless stated otherwise.
Figures 1a-c to 14a-b illustrate a method for forming a semiconductor device, according to some embodiments.
Figures 15a-b illustrate a device layer stack according to a further embodiment.
Figures 16a-c illustrate a device layer stack according to a further embodiment.

### Detailed description

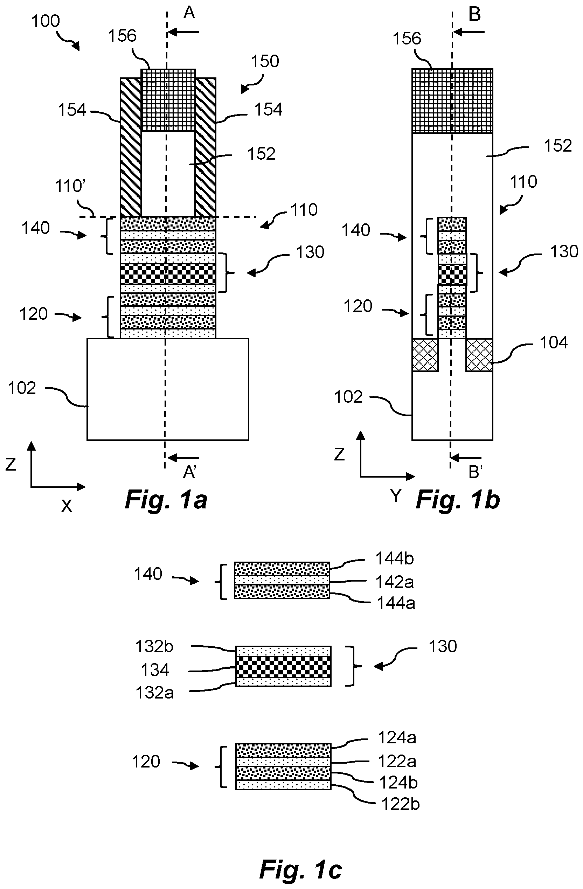

Figs. 1a-b depict a semiconductor device structure 100 at an initial stage of a method for forming a semiconductor device, in particular a stacked transistor device such as a CFET device.

Axes X, Y and Z indicate a first direction, a second direction transverse to the first direction, and a vertical or bottom-up direction, respectively. The X- and Y-direction may in particular be referred to as lateral or horizontal directions in that they are parallel to a main plane of a substrate 102 of the structure 100. The Z-direction is parallel to a normal direction to the substrate 102.

Figs. 1a-b depict respective cross-sectional views of the structure 100 taken along vertical planes B-B' (parallel to the XZ-plane) and A-A' (parallel to the YZ plane). The cross-sectional views of the subsequent figures correspond to those in Figs. 1a-b unless stated otherwise.

The structure 100 comprises a substrate 102 and a device layer stack 110 formed on the substrate 102. The substrate 102 may be a conventional semiconductor substrate suitable for complementary FETs. The substrate 102 may be a single-layered semiconductor substrate, for instance formed by a bulk substrate such as a Si substrate, a germanium (Ge) substrate or a silicon-germanium (SiGe) substrate. A multi-layered / composite substrate is however also possible, such as an epitaxially grown semiconductor layer on a bulk substrate, or a semiconductor-on-insulator (SOI) substrate, such as a Si-on-insulator substrate, a Ge-on-insulator substrate, or a SiGe-on-insulator substrate.

The device layer stack 110 comprises a first sub-stack 120, a second sub-stack 130 on the first sub-stack, and a third sub-stack 140 on the second sub-stack 130. Fig. 1c depicts the first sub-stack 120 (bottom), the second sub-stack 130 (middle) and the third sub-stack 140 (top) in isolation for illustrational clarity.

The first sub-stack 120 comprises a first sacrificial 122a and a channel layer 124a on the first sacrificial layer 122a. The channel layer 124 forms a topmost layer of the first sub-stack 120. The layers 122a and 124a may be referred to as one unit of the first sub-stack 120 and the first sub-stack 120 may as shown comprise further such consecutive layer-units, e.g. a first sacrificial layer 122b and a channel layer 124b on the first sacrificial layer 122b. Although Fig. 1c depicts two such units of the first sub-stack 120, it is to be understood that the first sub-stack 120 may comprise only a single unit (e.g. layers 122a/124a) or more than two such consecutively arranged layer-units (e.g. further units below the unit 122b/124b).

The second sub-stack 130 comprises a first sacrificial layer 132a, a second sacrificial layer 134 on the first sacrificial layer 132a, and a third sacrificial layer 132b on the second sacrificial layer 134. The layers 132a, 134, 132b are consecutive layers of the second sub-stack. The first sacrificial layer 132a forms a bottom (i.e. bottom-most) layer of the second sub-stack 130. The first sacrificial layer 132a is thus arranged on the first sub-stack 120, i.e. on the channel layer 124a. The third sacrificial layer 134 forms a topmost layer of the second sub-stack 130.

The third sub-stack 140 comprises a (first) channel layer 144a and a first sacrificial layer 142a on the channel layer 144a. The channel layer 144a forms a bottom (i.e. bottom-most) layer of the third sub-stack 140. The channel layer 144a is thus arranged on the second sub-stack 130, i.e. on the third sacrificial layer 132b. The third sub-stack 140 may as shown comprise a further (second) channel layer 144b on the sacrificial layer 142a. The layers 144a and 142a may be referred to as one unit of the third sub-stack 140 and the third sub-stack may more generally comprise a number of such consecutively arranged layer-units stacked on top of the layer-unit 144a/142a.

The first sacrificial layers of the first through third sub-stacks 120, 130, 140 (e.g. 122a, 122b, 132a, 132a) and the third sacrificial layer 132b of the second sub-stack 130 may be formed with a uniform or at least similar thickness.

The second sacrificial layer 134 may be formed with a greater thickness than each of the first sacrificial layers of the first through third sub-stacks 120, 130, 140 (e.g. 122a, 122b, 132a, 132a) and the third sacrificial layer 132b of the second sub-stack 130. The total thickness of the second sub-stack 130 may accordingly exceed a thickness of each first sacrificial layer of the first sub-stack 120, 130, 140 (e.g. 122a, 122b).

The channel layers 124 of the first and third sub-stacks 120, 140 may also be of a uniform or at least similar thickness, e.g. a different or a same thickness as the first sacrificial layers of the device layer stack 110.

By way of example, the channel layers 124 of the first and third sub-stacks 120, 140 may each be formed with a thickness of 3-10 nm, the first sacrificial layers of the first through third sub-stacks 120, 130, 140 (e.g. 122a, 122b, 132a, 132a) and the third sacrificial layer 132b of the second sub-stack 130 may each be formed with a thickness of 3-10 nm, and the second sacrificial layer 134 may be formed with a thickness of 10-30 nm. The total thickness of the second sub-stack 130 may for example be 20-50 nm. The thickness of any two layers of the first sacrificial layers of the first through third sub-stacks 120, 130, 140 and the third sacrificial layer 132b may differ by at most 1 nm, e.g. to facilitate the subsequent inner spacer formation.

Each first sacrificial layer of the first through third sub-stacks 120, 130, 140 (e.g. 122a, 122b, 132a, 132a) and the third sacrificial layer 132b of the second sub-stack 130 are formed of a same first sacrificial material. The second sacrificial layer 134 of the second sub-stack 130 is formed of a second sacrificial material different from the first sacrificial material. Each channel layer of the first and third sub-stacks 120, 140 (e.g. 122a, 122b, 144a, 144b) is formed of a same channel material, different from each of the first and second sacrificial materials.

For example, the channel material may be Si₁₋ₓGeₓ, the first sacrificial material may be Si_{1-y}Ge_{y} and the second sacrificial material may be Si_{1-z}Ge_{z}, wherein 0 ≤ x < y < z. For example, y ≥ x + 0.15 and z ≥ y + 0.15. In a more specific example, the channel material may be a Si, the first sacrificial material may be SiGe_{0.25}, and the second sacrificial material may be SiGe_{0.5} or SiGe_{0.65}. These relative differences in Ge-content facilitate a selective processing (e.g. selective etching) of the different sacrificial layers and the channel layers of the device layer stack 110.

The layers of the device layer stack 110 may each be epitaxial layers, e.g. epitaxially grown using deposition techniques which per se are known, such as chemical vapor deposition (CVD) or physical vapor deposition (PVD). This enables high quality material layers with an advantageous degree of control of composition and dimensions.

The deposited layers may be sequentially formed and subsequently patterned to define an elongated fin-shaped device layer stack, extending in the X-direction. The dashed line 110' schematically indicates a contour of a the device layer stack 110 subsequent to fin patterning and prior to fin recess, described below. While the figures depict only a single device layer stack, it is to be understood that a plurality of parallel fin-shaped device layer stacks may be formed. Conventional fin patterning techniques may be used, e.g. single patterning techniques such as lithography and etching ("litho-etch") or multiple-patterning techniques such as (litho-etch)x, self-aligned double or quadruple patterning (SADP or SAQP).

The layers of the layer stack 110 may each be formed as nanosheets, e.g. with a width (along Y) to thickness (along Z) ratio greater than 1, such as a width in a range from 10 nm to 30 nm and a thickness in a range from 3 nm to 10 nm. It is also possible to pattern the device layer stacks 20, 21 such that the channel layers form nanowire-shaped layers. A nanowire may by way of example have a thickness similar to the example nanosheet however with a smaller width, such as 3 nm to 10 nm.

As shown in Figs. 1a-b, subsequent to the fin patterning, a lower portion of the device layer stack 110 may be surrounded by a shallow trench isolation (STI) 104, e.g. of SiO₂.

As further shown in Figs. 1a-b, a sacrificial gate structure 150 may be formed to extend across the device layer stack 110'. The sacrificial gate structure 150 comprises a sacrificial gate body 152. The sacrificial gate body 152 may be formed by depositing a sacrificial gate body material (e.g. amorphous Si) over the device layer stack 110' and subsequently patterning the sacrificial gate body 152 therein. While the figures depict only a sacrificial gate structure 150, it is to be understood that a plurality of parallel sacrificial gate structures may be formed across the device layer stack 110'. Conventional patterning techniques may be used, e.g. single patterning techniques such as lithography and etching ("litho-etch") or multiple-patterning techniques such as (litho-etch)x, SADP or SAQP.

The sacrificial gate structure 150 further comprises a first spacer or first spacer layer 154 on opposite sides of the sacrificial gate body 152. The first spacer 154 may also be referred to as gate spacer 154. The gate spacer 154 may be formed by conformally depositing a gate spacer material and subsequently anisotropically etching the gate spacer material (e.g. top-down) to remove portions of the gate spacer material from horizontally oriented surfaces of the structure 100 and such that portions of the gate spacer material remain on the side surfaces of the sacrificial gate body 152 to form the gate spacer 154. The gate spacer 154 may be formed of dielectric material, e.g. as an oxide, a nitride or a carbide such as SiN, SiC, SiCO, SiCN or SiBCN deposited by ALD.

The sacrificial gate structure 150 may as shown further comprise a capping layer 156, e.g. formed of one or more layers of hardmask material remaining from the sacrificial gate body patterning.

After forming the sacrificial gate structure 150 the device layer stack 110 may be recessed by etching back the device layer stack 110 in a top down direction (e.g. negative Z) while using the sacrificial gate structure 150 as an etch mask. The etching may extend through each of the third, second and first sub-stacks 140, 130, 120 such that portions of each layer thereof are preserved underneath the sacrificial gate structure 150, as shown in Fig. 1a.

As will be apparent from the following, the first sacrificial layers of the first through third sub-stacks 120, 130, 140 (e.g. 122a, 122b, 132a, 132a) and the third sacrificial layer 132b will be subjected to the same process steps. Hence, for brevity, these layers will in the following be commonly denoted the first sacrificial layers of the device layer stack 110, or of the first sub-stack 120, the second sub-stack 130 or the third sub-stack. For corresponding reasons, the channel layers of the first and second sub-stacks 120, 140 (e.g. 124a, 124b and 144a, 144b) may in the following be commonly denoted the channel layers of the device layer stack 110, or of the first sub-stack 120 or the third sub-stack 140.

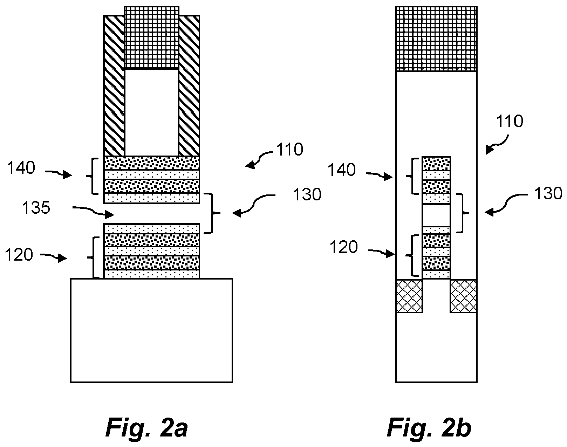

Figs. 2a-b to 4a-b show process steps for replacing the second sacrificial layer 134 of the second sub-stack 130 with a dielectric layer 136.

In Figs. 2a-b the second sacrificial layer 134 has been removed by selectively etching the second sacrificial semiconductor material, thereby forming a space 135 in the second sub-stack 130. The second sacrificial semiconductor material may be etched using an isotropic etching process (wet or dry), to laterally etch back end surfaces of the second sacrificial layer 134 from opposite sides of the sacrificial gate structure 150. For example, an HCI-based dry etch may be used to remove SiGe sacrificial layer material with a greater Ge-content than a Si or SiGe channel layer material. However, other appropriate etching processes (e.g. wet etching processes) are also known in the art and may also be employed for this purpose.

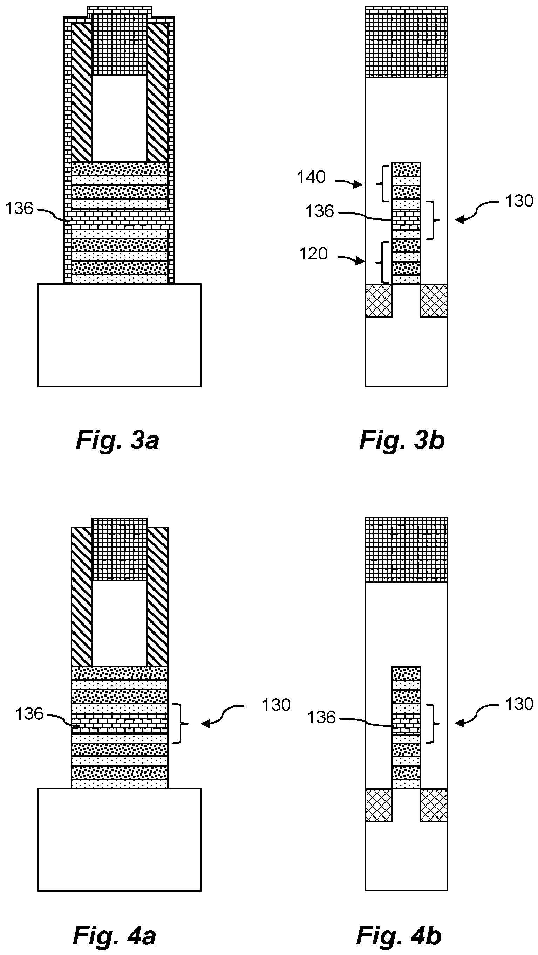

In Figs. 3a-b the space 135 has been filled with a first dielectric material, e.g. a nitride such as SiN. The first dielectric material may be conformally deposited (e.g. by ALD) with a thickness sufficient to fill (and pinch-off) the space 135. Examples of the first dielectric material include SiO₂, Si₃N₄, SiCO, SiOCN, SiON, SiCN, SiC, SiBCN, and SiBCNO.

In Figs. 4a-b the first dielectric material has been subjected to an isotropic etching process to remove portions of the first dielectric material deposited outside the space 135. Any suitable isotropic etching process (wet or dry) for etching the dielectric material (e.g. SiN) may be used. The first dielectric material remaining in the space 135 forms the dielectric layer 136.

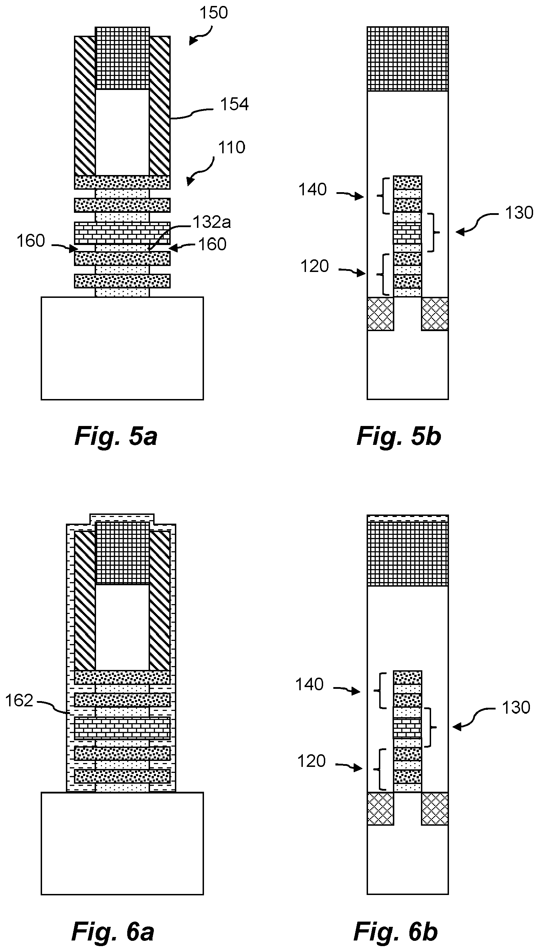

Figs. 5a-b to 7a-b show process steps for forming inner spacers 162.

In Figs. 5a-b, recesses 160 have been formed in the device layer stack 110 by laterally etching back (e.g. along the X- and negative X-direction) end surfaces of each first sacrificial layer of the device layer stack 110 from opposite sides of the sacrificial gate structure 150 (e.g. the first sacrificial layer 132a). The lateral etch back may be achieved by an isotropic etching process. Any suitable dry etching process or wet etching process allowing selective etching of the first sacrificial material may be used (e.g. HCI, or APM). As indicated in Fig. 5a, the extent of the lateral etch back may correspond to a thickness of the gate spacer 154. In other words a depth of the recesses 160 (e.g. along the X-direction) may correspond to the thickness of the gate spacer 154 (along the X-direction).

In Figs. 6a-b, the recesses 160 have been filled with one or more conformally deposited inner spacer materials. Examples of inner spacer materials include conformally deposited dielectric materials, e.g. as an oxide, a nitride or a carbide, for example a same material as the dielectric layer 136 (e.g. SiN deposited by ALD). In one example, a single inner spacer material (e.g. SiN) may be deposited to fill the recesses 160. In another example, a first inner spacer material (e.g. SiOC) may be deposited to partially fill the recesses 160 wherein a second inner spacer material (e.g. SiN) may be deposited to fill (by pinch-off) a remaining space in the recesses 160.

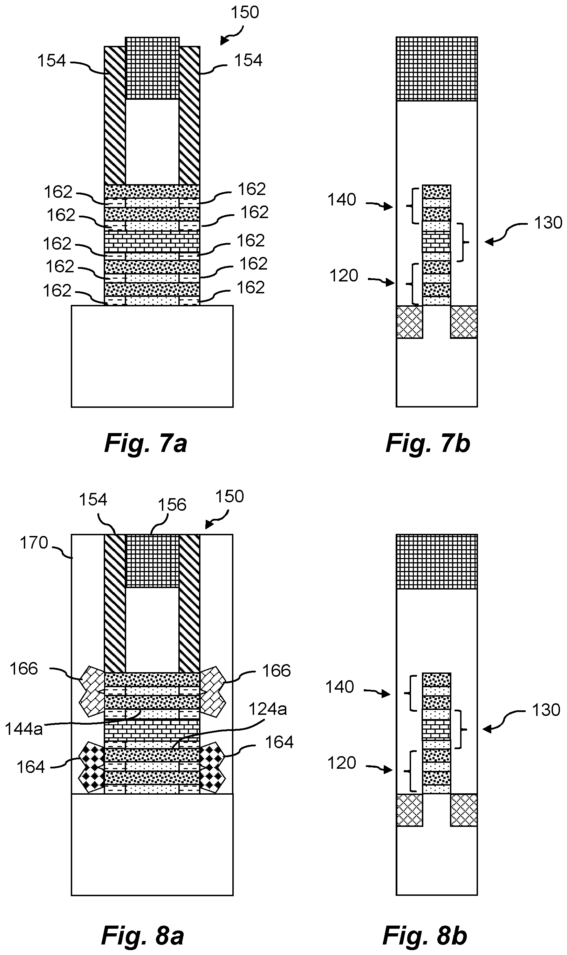

In Figs. 7a-b the inner spacers 162 have been formed in the recesses 160 by subjecting the inner spacer material to an isotropic etching process to remove portions of the inner spacer material deposited outside the recesses 160. Any suitable isotropic etching process (wet or dry) for etching the dielectric material (e.g. SiN or SiN and SiOC) may be used. The etching may as shown be stopped when end surfaces of the channel layers of the device layer stack 110 are exposed and discrete portions of the inner spacer material remain in the recesses 160 to form the inner spacers 162.

In Figs. 8a-b, source and drain regions 164 and 166 have been formed on the channel layers of the first sub-stack 120 and the third sub-stack 140, respectively. The source and drain regions 164, 166 have been formed by epitaxially growing semiconductor material on end surfaces of the channel layers exposed at opposite sides of the sacrificial gate structure 150.

The source and drain regions 164 formed on the channel layer end surfaces of the first sub-stack 120 may be of a first conductivity type and the source and drain regions 166 formed on the channel layer end surfaces of the third sub-stack 140 may be of a second opposite conductive type. The first and second conductivity types may be a p-type and an n-type, or vice versa. The doping may be achieved by in-situ doping. Different conductivity types of the source and drain regions 164 and the source and drain regions 166 may be achieved by masking the channel layer end surfaces of the third sub-stack 140 while performing epitaxy on the channel layer end surfaces of the first sub-stack 120. The masking of the channel layer end surfaces of the third sub-stack may for example be provided by forming a temporary cover spacer along the third sub-stack. After completing the epitaxy of the source and drain regions 164, the temporary cover spacer may be removed and the source and drain regions 164 may be covered with one or more dielectric materials (e.g. ALD-deposited SiN and an inter-layer dielectric like SiO₂). Epitaxy may then be performed on the channel layer end surfaces of the third sub-stack 140. This is however merely one example and other process techniques facilitating forming of the source and drain regions 164, 166 with different conductivity types may also be used.

The source and drain regions 164, 166 may as shown subsequently be covered by an insulating layer 170. The insulating layer 170 may be formed of an insulating material, such as an oxide, e.g. SiO₂, or another inter-layer dielectric, deposited, planarized and recessed, e.g. by chemical mechanical polishing (CMP) and/or etch back. The CMP and/or etch back may proceed to also remove any capping 156 of the sacrificial gate structure 150. It is however also possible to stop the CMP and/or etch back on the capping 156 and subsequently open the capping using a separate etch step.

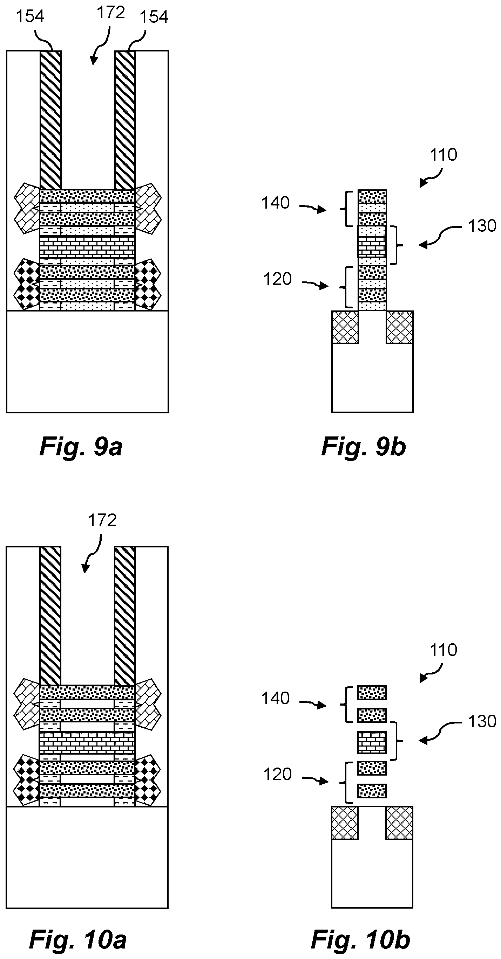

In Figs. 9a-b a gate trench 172 has been formed by removing the sacrificial gate body 152 between the opposite gate spacers 154. Any conventional suitable etching process (isotropic or anisotropic, wet or dry) allowing selective removal of the sacrificial gate body 152 (e.g. of amorphous Si) may be used.

In Figs. 10a-b the first sacrificial layers of the device layer stack 110 have been removed by selectively etching the first sacrificial semiconductor material from the gate trench 172. A same type of etching process may be used for this step as during the forming of the recesses 160. By removing the first sacrificial layers, the channel layers of the device layer stack 110 may be released in the sense that upper and lower surfaces thereof may be exposed within the gate trench 172. As the dielectric layer 154 prior to this process step was surrounded by first dielectric layers (e.g. the first dielectric layer 132a and the third dielectric layer 132b of the second sub-stack 130), also the dielectric layer 154 is released.

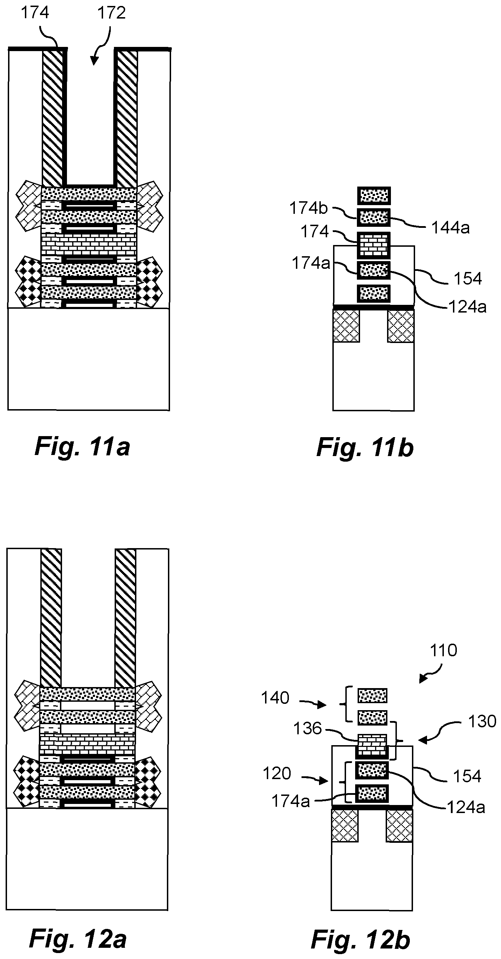

Figs. 11a-b to Figs. 14a-b illustrate process steps for forming a gate stack 180 surrounding the released channel layers and the dielectric layer 136 in the gate trench 172.

In Figs. 11a-b, a gate dielectric layer and then a first gate work function metal (WFM) 174 have been conformally deposited in the gate trench 172. The gate dielectric layer is for illustrational clarity not individually shown in the figures but its coverage may correspond with that indicated for layer 174. The gate dielectric layer may be formed of a conventional a high-k dielectric e.g. HfO₂, HfSiO, LaO, AIO or ZrO. The first WFM 174 may be formed of one or more effective WFMs (e.g. an n-type WFM such as TiAl or TiAIC and/or a p-type WFM such as TiN or TaN). The gate dielectric layer and the first WFM may be deposited by ALD.

As further shown in Fig. 11b, a block mask 154 may subsequently be formed in a lower part of the gate trench 172. The block mask 154 may be formed a thickness (e.g. along the Z-direction) such that the portions of the first WFM 174 surrounding the channel layers of the first sub-stack 120 (e.g. portion 174a surrounding the channel layer 124a) is covered and the portions of the first WFM 174 surrounding the channel layers 144a of the third sub-stack 140 (e.g. the portion 174b surrounding the channel layer 144a) are exposed.

The block mask 154 may be formed by depositing a block mask material filling the gate trench 172. The block mask material may e.g. be spin-on-carbon or another organic spin-on material. The block mask material may subsequently be etched back top-down (e.g. using an anisotropic etch) to a target level. The target level may as shown be located along the dielectric layer 136. The portions of the first WFM 174 surrounding the channel layers of the third sub-stack 140 may thus be exposed.

In Figs. 12a-b, the first WFM 174 has been removed from the channel layers of the third sub-stack 140 while using the block mask 154 as an etch mask. Depending on the particular thickness of the block mask 154, at least a portion of the first WFM 174 surrounding the dielectric layer 136 may also be removed. The first WFM 174 surrounding the channel layers to the first sub-stack 120 (e.g. the portion 174a surrounding the channel layer 124a) may however be preserved, due to the block mask 154.

The first WFM 174 may be removed using a suitable isotropic (wet or dry) etch, allowing selective removal of the first WFM 174 without removing the gate dielectric. Subsequently, the block mask 154 may be removed from the trench 172.

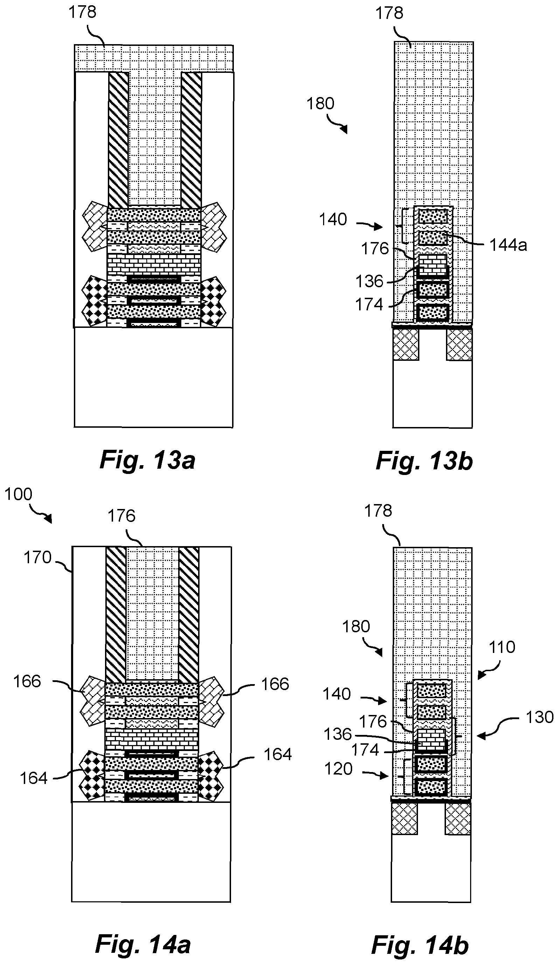

In Figs. 13a-b, a second gate WFM 176 has been conformally deposited in the gate trench 172. The second WFM 176 may be deposited on the gate dielectric surrounding the channel layers of the third sub-stack 140, and on portions of the gate dielectric exposed on the dielectric layer 136. The second WFM 176 may thus surround the channel layers of the third sub-stack 140. As shown in Figs. 13a-b, the second gate WFM 176 may further be deposited on the first WFM 174 surrounding the channel layers of the first sub-stack 140.

Subsequently, a gate fill metal 178 (such as W, Al, Co or Ru) may be deposited to fill a remaining space of the gate trench 172. The gate fill metal 176 may for instance be deposited by CVD or PVD.

Reference sign 180 indicates the full gate stack, comprising a lower portion comprising the gate dielectric layer, the first WFM 174, the second WFM 176 and the gate fill metal 178 surrounding the channel layers of the first sub-stack 110, and an upper portion comprising the gate dielectric, the second WFM 176 and the gate fill metal 178 surrounding the channel layers of the third sub-stack 140.

Figs. 14a-b depicts the resulting device structure 100 subsequent to a gate metal recess to bring a top surface of the gate stack 180 flush with an upper surface of the gate spacers 154.

The device structure 100 comprises a bottom device comprising the channel layers of the first sub-stack 120, extending between the source and drain regions 164, and the lower portion of the gate stack 180. The device structure 100 further comprises a bottom device comprising the channel layers of the third sub-stack 140, extending between the source and drain regions 166, and the upper portion of the gate stack 180. The dielectric layer 136 remains as an electrically inactive dummy channel, between the channels of the bottom device and the top device and surrounded by the gate stack 180.

The method may thereafter proceed with forming source/drain contacts by etching contact trenches in the insulating layer 170 and depositing one or more contact metals in the trenches, on the source and drain regions 164, 166. Separate contacting of the source and drain regions of the bottom device and the top device may be achieved by a first contact metal deposition over the source and drain regions 164, 166, etch back of the contact metal to a level between the source and drain regions 164 and 166, thus exposing the source and drain regions 166, deposition of an insulating contact separation layer on the etched back contact metal, and subsequently a second contact metal deposition over the source and drain regions 166. Separate source and drain contacting may be applied to either or both sides of the device 100.

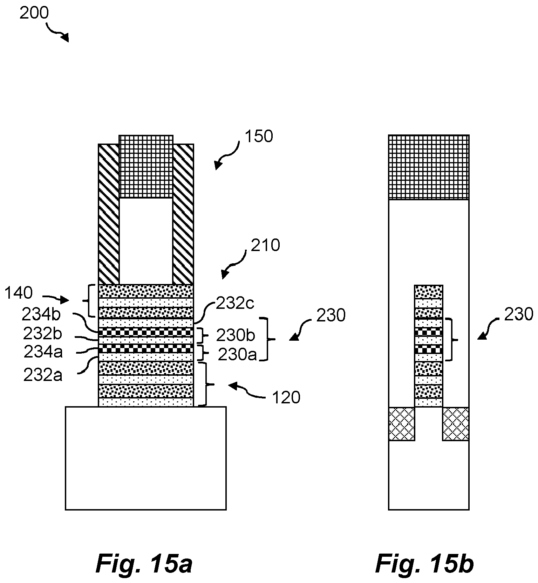

Figs. 15a-b depicts a semiconductor device structure 200 comprising a device layer stack according to a further embodiment. The device layer stack 210 is similar to the device layer stack 110 however differs in that the second sub-stack 220 thereof has a different composition. The second sub-stack 220 comprises exactly two units of a first sacrificial layer 232a, 232b of the first sacrificial semiconductor material and a second sacrificial layer 234a, 234b on the first sacrificial layer. That is, the second sub-stack 220 comprises a first layer-unit 230a of the first sacrificial layer 232a and the second sacrificial layer 234a, and a second layer-unit 230b of the first sacrificial layer 232b and the second sacrificial layer 234b. The second sub-stack 220 further comprises a third sacrificial layer 232c of the first sacrificial semiconductor material as a top-most layer of the sub-stack 220. The second sub-stack is hence formed as a five-layer sub-stack, with a bottom sacrificial layer 232a and a topmost sacrificial layer 232c of the first sacrificial material, and two second sacrificial layer 234a, 234b of the second sacrificial material separated by a middle sacrificial layer 232c of the first sacrificial material between the two second sacrificial layers 234a, 234b. Applying the method steps described with reference to the preceding figures may thus result in two dielectric layers replacing the two second sacrificial layers 234a, 234b, which may form two dummy channels in the final gate stack. The layers of the second sub-stack 220 may as shown be formed with a uniform thickness, or at least similar thickness. For example, each of the first sacrificial layers of the first through third sub-stacks 120, 330, 140, the third sacrificial layer 232c of the second sub-stack 230, and the second sacrificial layers 234a, 234b of the second sub-stack 230, may each be formed with a thickness of 3-10 nm. The thickness of any two layers of the sacrificial layers of the first through third sub-stacks 120, 130, 140 may differ by at most 1 nm.

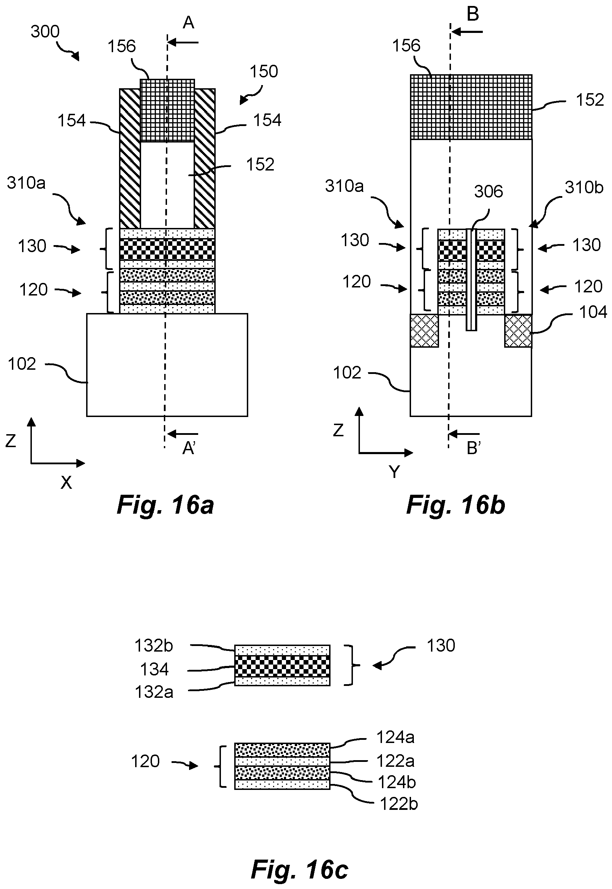

Figs. 16a-c depicts a semiconductor device structure 300 according to a further embodiment, comprising a first and a second device layer stack 310a, 310b. Each one of the device layer stacks 310a and 310b is similar to the device layer stack 110 however differs in that the respective second sub-stack 130 thereof (which has a same composition as the sub-stack 130 of device layer stack 110) forms a topmost sub-stack, such that the topmost channel layer 124a of the first sub-stack 120 forms a topmost channel layer of the respective device layer stacks 310a, 310b. Additionally, the third sacrificial layer 134 of the second sub-stack 130 of the respective device layer stacks 310a, 310b forms a topmost sacrificial layer of the respective device layer stacks 310a, 310b. It is to be understood that the view in Fig. 16a is representative also to the second device layer stack 310b.

The first and second device layer stacks 310a, 310b are separated by a vertically oriented insulating wall 306 such that the layers of the respective sub-stacks 120, 130 abut opposite side surfaces of the insulating wall 306. The insulating wall 306 may be formed in connection with a fin patterning process, by etching a trench partitioning an initial device layer stack into two corresponding device layer stacks 310a, 310b, and filling the trench with an insulating wall material, e.g. an oxide or nitride deposited by for instance by ALD. The trench and the wall 306 may as shown extend into a thickness portion of the substrate 102.

During formation of the insulating wall 306, the presence of the second sub-stacks 130 of the first and second device layer stacks 310a, 310b may facilitate forming the insulating wall 306 with an increased height above the top-most channel layer 124a.

The method may subsequently generally proceed as described in connection with Figs. 1a-b and onwards by forming a sacrificial gate structure 150 across the first and second device layer stacks 310a, 310b and the insulating wall 306. Thereafter each of the device layer stacks 310a, 310b may be etched through (i.e. recessed) to form recessed device layer stacks 310a, 310b as shown in Fig. 16a. Subsequently, the second sacrificial layer 134 of each device layer stack 310a, 310b may be replaced with a dielectric layer (c.f. dielectric layer 136 formed in Figs. 2a-b to 4a-b). Recesses and inner spacers may then be formed in each device layer stack 310a, 310b (c.f. recesses 160 and inner spacers 162 formed in Figs. 5a-b to 7a-b). Thereafter, source/drain regions may be formed on end surfaces of the channel layers of each device layer stack 310a, 310b, at opposite sides of the sacrificial gate structure 150 (c.f. the source and drain regions 164 formed on the channel layers of the first sub-stack 120 in Fig. 8a). Source/drain regions of p-type and source/drain regions of n-type may be formed sequentially on opposite sides of the insulating wall 306 by masking the device layer stack (e.g. 310a or 310b) at the opposite side of the insulating wall 306. The insulating wall 306 may facilitate separation between the p- and n-type source/drain regions. The source/drain regions may be covered by an insulating layer (c.f. layer 170 in Fig. 8a).

The sacrificial gate structure 150 may thereafter be replaced by functional gates stacks. The replacement may proceed in accordance with a replacement metal gate (RMG) flow: Gate trenches may be formed on opposite sides of the insulating wall 306 by removing the sacrificial gate body 152. An n-side (or p-side) and a p-side (or n-side) gate trench exposing respectively the device layer stacks 310a, 310b may hence be formed, separated by the insulating wall 306. The RMG flow may proceed by gate dielectric deposition (e.g. high-K dielectric such as HfO₂, HfSiO, LaO, AIO or ZrO), gate work function metal deposition and gate (metal) fill deposition.

The process may further comprise a step of channel release, interleaved in the RMG process: That is, subsequent to forming the gate trenches, selectively removing the first sacrificial layers 122a, 122b, 132a and 132b of each device layer stack 310a, 310b. Suspended channel layers 124a, 124b (e.g. nanosheets) may hence be defined in each gate trench. Due to the presence of the insulating wall 306, the channel layers 124a, 124b will be "partly released" in the sense that their upper and lower surfaces as well as outer sidewall surfaces may be laid bare while their inner sidewall surfaces abut the insulating wall 306.

For improved device performance a p-type work function metal (pWFM) may be provided in the p-type device region (e.g. in the p-side gate trench) and a n-type work function metal (nWFM) may be provided in the n-type device region (e.g. in the n-side gate trench). The gate metal deposition may hence comprise sub-steps: (a) pWFM deposition in the p- and n-type device regions; (b) selective removal of the pWFM from the n-type device region; (c) nWFM deposition in the n-type device region, and optionally also the p-type device region; (d) gate fill deposition. The pWFM removal may comprise etching the pWFM in the n-type device region while masking the p-type device region. The insulating wall 306 may counteract lateral etching of the pWFM in the p-type device region. In this sequence of sub-steps, reference to "pWFM" may be substituted by "nWFM" and vice versa. Recessing of the functional gate stacks, and optionally, gate cut formation, may then follow. The method may further comprise forming source/drain contacts on the source/drain regions.

An alternative to the three-layered second sub-stack 130 of the first and second device layer stacks 310a, 310b shown in Figs. 16a-c is a two-layered second sub-stack, similar to the second sub-stack 130 however omitting the third sacrificial layer 132b such that the second sacrificial layer 134 forms a top-most sacrificial layer of the respective second sub-stacks 130. The method for forming a forksheet device outlined above may be applied in a similar fashion also to such device layer stacks.

In the above the inventive concept has mainly been described with reference to a limited number of examples. However, as is readily appreciated by a person skilled in the art, other examples than the ones disclosed above are equally possible within the scope of the inventive concept, as defined by the appended claims.

## Claims

1. A method for forming a semiconductor device (100), the method comprising:
forming a device layer stack (110) on a substrate (102), the device layer stack comprising:
- a first sub-stack (120) comprising a first sacrificial layer (122a) and on the first sacrificial layer (122a) a channel layer (124a) defining a topmost layer of the first sub-stack (120), and
- a second sub-stack (130) on the first sub-stack (120) and comprising a first sacrificial layer (132a) defining a bottom layer of the second sub-stack (130), and a second sacrificial layer (134) on the first sacrificial layer (132a),
wherein said first sacrificial layers (122a, 132a) are formed of a first sacrificial semiconductor material, the second sacrificial layer (134) is formed of a second sacrificial semiconductor material, and the channel layer (124a) is formed of a semiconductor channel material, and
wherein a thickness of the second sub-stack (130) exceeds a thickness of the first sacrificial layer (122a) of the first sub-stack (120);
forming a sacrificial gate structure (150) extending across the device layer stack (110), the sacrificial gate structure (150) comprising a sacrificial gate body (152) and a first spacer (154) on opposite sides of the sacrificial gate body (152);
etching through the device layer stack (110) while using the sacrificial gate structure (150) as an etch mask such that portions of said layers (122a, 124a, 132a, 134) of the device layer stack (110) are preserved underneath the sacrificial gate structure (150);
subsequently, replacing the second sacrificial layer (134) of the second sub-stack (130) with a dielectric layer (136), comprising removing the second sacrificial layer of the second sub-stack to form a space (135) in the second sub-stack (130) by selectively etching the second sacrificial semiconductor material, and thereafter filling the space (135) with a first dielectric material;
forming recesses (160) in the device layer stack (110) by laterally etching back end surfaces of the first sacrificial layers (122a, 132a) of the first and second sub-stacks (120, 130) from opposite sides of the sacrificial gate structure (150);
forming inner spacers (162) in the recesses (160);
subsequently, forming source and drain regions (164) by epitaxially growing semiconductor material on end surfaces of the channel layer (124a) exposed at opposite sides of the sacrificial gate structure (150);
subsequently, forming a gate trench (172) by removing the sacrificial gate body (152);
removing the first sacrificial layer (122a, 132a) of the first and second sub-stacks (120, 130) by selectively etching the first sacrificial semiconductor material from the gate trench (172); and
forming a gate stack (180) in the gate trench (172) such that the gate stack (180) surrounds the channel layer (124a).

2. A method according to claim 1, wherein said act of replacing the second sacrificial layer (134) of the second sub-stack (130) with a dielectric layer (136), is performed prior to said act of forming the recesses (160).

3. A method according to any one of the preceding claims, wherein the second sub-stack (130; 230) comprises one or more units (130; 230a, 230b) of a first sacrificial layer (132a; 232a, 232b) of the first sacrificial semiconductor material and a second sacrificial layer (134; 234a, 234b) of the second sacrificial semiconductor material,
wherein the method comprises replacing each second sacrificial layer (134; 234a, 234b) of the second sub-stack (130; 230) with a dielectric layer (136; 236a, 236b),
wherein said act of forming recesses (160) comprises laterally etching back end surfaces of each first sacrificial layer (122a, 132a; 232a, 232b) of the first and second sub-stacks (120, 130; 220, 230) from opposite sides of the sacrificial gate structure (150), and
wherein the method comprises removing each first sacrificial layer (122a, 132a) of the first and second sub-stacks (120, 130).

4. A method according to claim 3, wherein the second sub-stack (130; 230) further comprises a third sacrificial layer (132b) of the first sacrificial material forming a topmost layer of the second sub-stack (130), and wherein the device layer stack (110) further comprises a third sub-stack (140) on the second sub-stack (130) and comprising a channel layer (144a) of the channel material and forming a bottom layer of the second sub-stack (140), and a first sacrificial layer (142a) of the first sacrificial semiconductor material on the channel layer (144a),
wherein said act of forming recesses (160) comprises laterally etching back end surfaces of each first sacrificial layer (132a, 142a) of the first, second and third sub-stack (140) and the third sacrificial layer (132b) of the second sub-stack from opposite sides of the sacrificial gate structure (150),
wherein said act of forming source and drain regions further comprises epitaxially growing semiconductor material on end surfaces of the channel layer (144a) of the third sub-stack (140), exposed at opposite sides of the sacrificial gate structure (150),
wherein the method comprises removing each first sacrificial layer (122a, 132a) of the first, second and third sub-stacks (120, 130, 140) and the third sacrificial layer (132b) of the third sub-stack (140), and
wherein said act of forming a gate stack (180) comprises forming the gate stack (180) in the gate trench (172) such that the gate stack (180) surrounds the channel layer (124a) of the first sub-stack (120), each dielectric layer (136) of the second sub-stack (130), and the channel layer (144a) of the third sub-stack (140).

5. A method according to claim 4, wherein the second sub-stack (130) comprises exactly one unit of a first sacrificial layer (132a) of the first sacrificial semiconductor material and a second sacrificial layer (134) of the second sacrificial semiconductor material, and the third sacrificial layer (132b) of the first sacrificial semiconductor material on said one unit.

6. A method according to claim 5, wherein the second sacrificial layer (134) of the second sub-stack (140) has a greater thickness than the first and third sacrificial layers of the second sub-stack (130).

7. A method according to claim 6, wherein the second sub-stack (130) comprises exactly two units of a first sacrificial layer (132a) of the first sacrificial semiconductor material and a second sacrificial layer (134) of the second sacrificial semiconductor material, and the third sacrificial layer (132b) of the first sacrificial semiconductor material on an upper one of said units.

8. A method according to claim 7, wherein each first and second sacrificial layers of the second sub-stack (130), and the third sacrificial layer (132b) have a similar thickness.

9. A method according any claim 4-8, wherein forming the gate stack (180) further comprises:
conformally depositing a gate dielectric layer and then a first gate work function metal (174) in the gate trench (172),
subsequently, forming a block mask (154) with a thickness such that the first gate work function metal (174) surrounding the channel layer (124a) of the first sub-stack (120) is covered and the first gate work function metal (174) surrounding the channel layer (144a) of the third sub-stack (140) is exposed,
removing the first gate work function metal (174) from the channel layer (144a) of the third sub-stack (174) while using the block mask (154) as an etch mask, and
subsequently conformally depositing a second gate work function metal in the gate trench (172).

10. A method according to claim 9, wherein forming the block mask (154) comprises depositing a block mask material filling the gate trench (172), and subsequently etching back the deposited block mask material such that the first gate work function metal (174) surrounding the channel layer (144a) of the third sub-stack (140) is exposed and such that the first gate work function metal (174) surrounding the channel layer (124a) of the first sub-stack (120) remains covered.

11. A method according to any one of claims 4-10, wherein the third sub-stack (140) comprises one or more units of a channel layer (144a) of the channel material and a first sacrificial layer (142a) of the first sacrificial semiconductor material on the channel layer.

12. A method according to any one of the preceding claims, wherein the first sub-stack (120) comprises one or more units of a first sacrificial layer (122a, 122b) of the first sacrificial semiconductor material and a channel layer (124a, 124b) of the channel material on the first sacrificial layer.

13. A method according to any one of the preceding claims, wherein the channel material is Si₁₋ₓGeₓ, the first sacrificial material is Si_{1-y}Ge_{y} and the second sacrificial material is Si_{1-z}Ge_{z}, wherein 0 ≤ x < y < z.

14. A method according to any one of claims 1-3, or any one of claims 12-13 when dependent on any one of claims 1-3, wherein the device layer stack is a first device layer stack (310a), and the channel layer of the first sub-stack (120) forms a top-most channel layer of the first device layer stack (310a), and wherein the method further comprises:
forming a second device layer stack (310b) on the substrate (102), the second device layer stack (310b) having a same composition as the first device layer (310a), and the first and second device layer stacks being separated by a vertically oriented insulating wall (306), wherein the layers of the first and second sub-stacks (120, 130) of the first device layer stack (310a) and the layers of the first and second sub-stacks (120, 130) of the second device layer stack (310b) abut opposite side surfaces of the insulating wall (306),
wherein the method comprises forming the sacrificial gate structure (150) to extend across the first and second device layer stacks (310a, 310b) and the insulating wall (306), and
subsequently applying each one of said acts of etching through the device layer stack, replacing the second sacrificial layer of the second sub-stack, forming recesses, forming inner spacers, forming source and drain regions, forming a gate trench, removing the first sacrificial layers of the first and second sub-stacks, and forming a gate stack to each of the first device layer stack and the second device layer stack.
